Europäisches Patentamt

(19) European Patent Office

Office européen des brevets

(11) Publication number:

**0 078 323**

**B1**

(12) **EUROPEAN PATENT SPECIFICATION**

(45) Date of publication of patent specification: **14.01.87**

(21) Application number: **82902107.0**

(22) Date of filing: **17.05.82**

(86) International application number:
**PCT/US82/00668**

(87) International publication number:
**WO 82/04133 25.11.82 Gazette 82/28**

(51) Int. Cl.⁴: **G 03 B 27/42**

(54) **APPARATUS FOR PROJECTING A SERIES OF IMAGES ONTO DIES OF A SEMICONDUCTOR WAFER.**

(30) Priority: **15.05.81 US 264171**
**15.05.81 US 264249**
**14.05.82 US 378370**

(43) Date of publication of application:
**11.05.83 Bulletin 83/19**

(45) Publication of the grant of the patent:
**14.01.87 Bulletin 87/03**

(84) Designated Contracting States:
**·FR**

(56) References cited:
**US-A- 198 159**
**US-A-3 796 497**
**US-A-3 809 050**
**US-A-3 818 327**
**US-A-3 917 399**
**US-A-3 951 546**
**US-A-4 084 903**
**US-A-4 131 267**
**US-A-4 171 870**
**US-A-4 171 871**
**US-A-4 295 735**
**US-A-4 298 273**

(73) Proprietor: **GENERAL SIGNAL CORPORATION**
**PO Box 10010 High Ridge Park**
**Stamford Connecticut 06904 (US)**

(72) Inventor: **HERSHEL, Ronald S.**
**4828 Springhill Road**
**Albany, OR 97321 (US)**
Inventor: **LEE, Martin E.**
**13350 Via Arriba Avenue**
**Saratoga, CA 95070 (US)**

(74) Representative: **Monnier, Joseph et al**
**Cabinet Monnier 142-150, Cours Lafayette**
**F-69003 Lyon (FR)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Description

The invention concerns apparatuses for microlithographically forming patterns on semiconductor wafers. More particularly, the invention concerns an improved system for one-to-one projection of pattern images onto a predetermined focal plane.

US—A—4 198 159 discloses a sensing head the back pressure of which influences the positions of a switch which in turn controls via a motor and an air regulator the flow of air to a pneumatic flexure unit.

This document does not show a system in which the detection of the position of the wafer and the repositioning of the wafer to a desired position are both accomplished using only fluidically actuated means.

The invention provides an apparatus for projecting an image of a reticle pattern onto a wafer, with one-to-one magnification. The apparatus includes means for holding a reticle containing a pattern corresponding to the size of the desired wafer pattern. An illumination system substantially uniformly illuminates the reticle pattern. A stationary one-to-one projection optical system projects an image of the reticle pattern onto a predetermined focal plane. Suitable means such as a vacuum chuck holds the wafer. An alignment system steps and orients the wafer chuck to register markings on the individual dies of the wafer with corresponding markings on the projected image of the reticle pattern. A fluid servo system acts on the chuck to hold at least a portion of the wafer in the predetermined focal plane of the projection optical system.

A system for focusing a wafer in an apparatus such as a projection stepping machine for microlithographically forming patterns on semiconductor wafers is, according to the invention, characterized in that it comprises pneumatic conduit means connected between generating means and moving means for conveying a fluid pressure signal to said pneumatic moving means and for actuating said moving means in response to changes in said signal to adjust the distance between said wafer and said focal plane, and thereby positioning directly through fluidic means said wafer in said focal plane.

A projecting stepping machine having a focusing system according to the invention is characterized by claims 2 to 10.

Figure 1 is a plan view of a typical wafer having a plurality of dies formed thereon.

Figure 2 is an enlarged fragmentary view of the wafer of Fig. 1, showing the dies on the wafer and the fiducial marks on the dies.

Figure 3 is a perspective, schematic view of a projection stepper.

Figure 4 is a simplified plan view of the wafer platform of the projection stepper.

Figure 5 is a fragmentary sectional and partly schematic view of a portion of the wafer platform and focusing system, taken on line 5—5 of Fig. 4.

Figure 6 is a fluid schematic of the focusing system.

Figure 7 is a partial front elevational view of the projection stepper showing the illumination system and portions of the projection system in phantom lines.

Figure 8 is a detailed plan view of the wafer platform with portions of the focusing system shown in phantom.

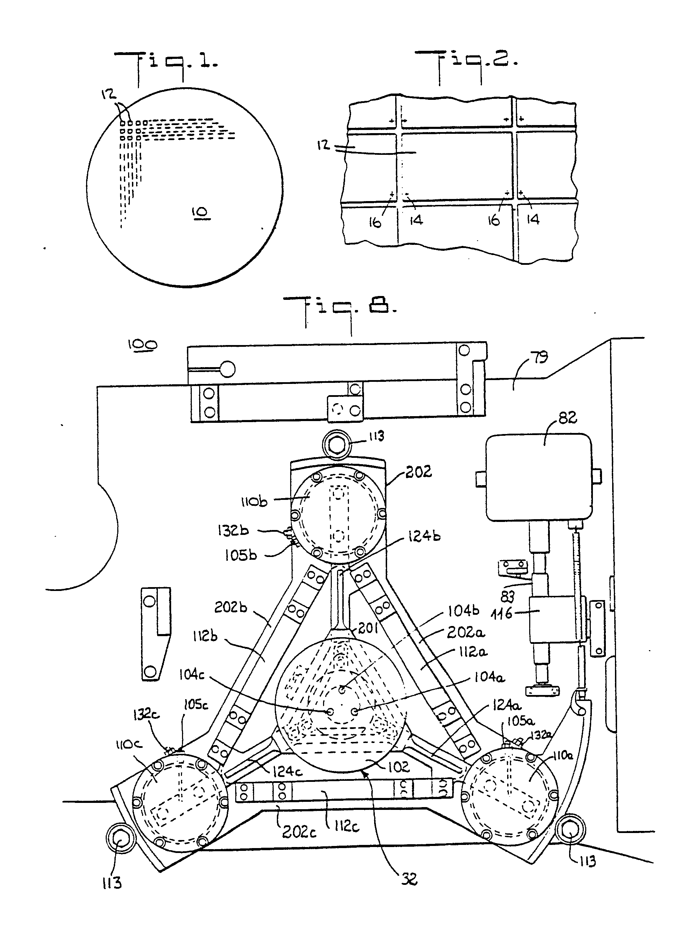

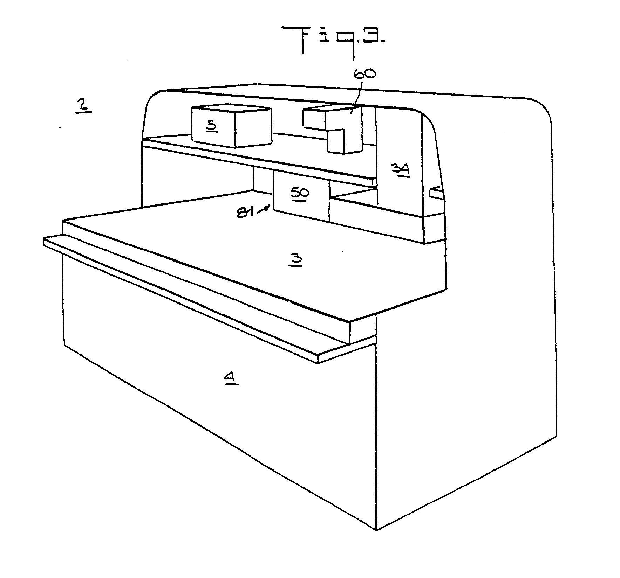

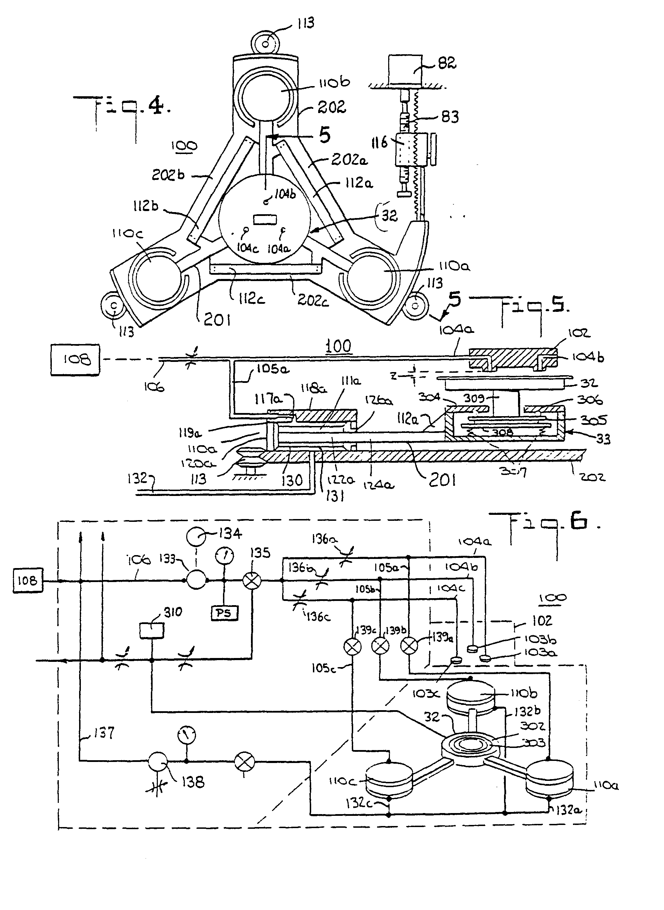

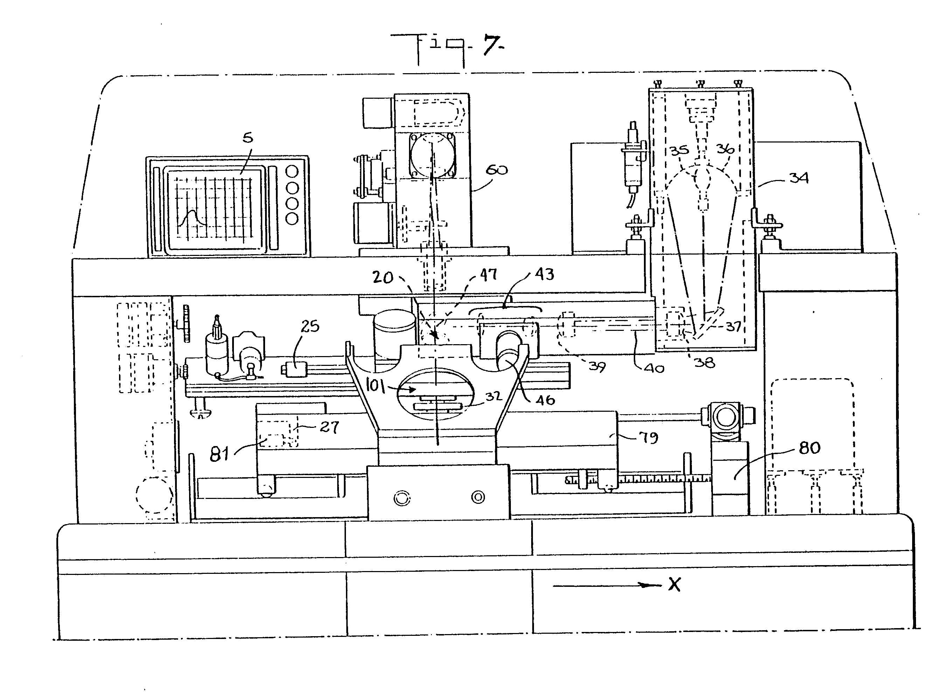

Figures 3 and 7 show perspective and front elevation views of a projection stepping machine according to the invention. A shelf 3 supports a wafer positioning system or platform 79 including a chuck 32 shown in Fig. 4—6, 7 et 8. Underneath the shelf 3 is space 4 to hold power supplies and a computer (not shown). Above the shelf 3 are the illumination system 34, projection system 50, a dark field automatic alignment system 60, and a cathode ray tube display 5 for monitoring the alignment system 60.

In operation a reticle 20 is disposed between illumination system 34 and projection system. Alignment system 60 controls the movement of the wafer positioning system or platform 79 to align the dies 12 of a wafer 10 shown in Figs. 1 and 2 with the projected image of the pattern on reticle 20. A focusing system 100 shown in Figs. 4, 6, 7 et 8 maintains the projected image of the reticle pattern in optimal focus on the wafer. The power output of illumination system 34 is increased to develop the exposed (non-imaged) areas of the dies 12. After exposure, the wafer positioning system is moved or stepped to bring another portion of the wafer 10 into alignment and focus with the projected reticle image.

Figs. 1 and 2 show a wafer 10 provided with a plurality of dies 12 arranged in rows and columns. Each die 12 has a pair of fiducial markers 14 and 16 at adjacent or opposite corners of the die. The markers 14 and 16 may be in the form of small "+" signs. As will be described in detail hereinafter, the markers 14 and 16 are used to align the dies with the projected image of the reticle pattern.

Holding means, such as a vacuum chuck 32 shown in Figs. 4—6, 7 and 8, is disposed below projection system 50. Chuck 32 is moveable rectilinearly in two coordinate directions, such as X and Y directions, to align one of markers 14, 16 on the dies 12 with one markers 28, 30 on the projected images of reticle 20. The chuck is also rotatable in the same plane as that defined by the X and Y directions, to align the other of markers 14, 16 on the dies 12 with the other of markers 28, 30 on the projected images of reticle 20. Chuck 32 is also moveable vertically to provide an optimal focusing of the projected images on the dies 12, as will be discussed subsequently. The chuck 32 is provided on its upper surface with a plurality of concentric narrow lapped lands 302 shown in Fig. 6. Relatively wide grooves 303 separate lands 302 for wringing in the wafer 20 to lie substantially flat on lands 302 as described hereinafter.

As shown in Figs. 7 and 8, chuck 32 is disposed on the platform 79 supported on air bearings in a well known manner. Motors 80, 81 (Fig. 7), and 82 (Fig. 8) are respectively associated with the platform 79. Motors 80 et 81 are respectively coupled to the platform 79 to move it horizontally in X and Y coordinate directions in a conventional manner. Motor 82 is coupled to the platform 79 through a lead screw 83 to rotate the platform about a vertical axis extending through the center of the chuck 32.

A computer (not shown) processes the signals produced by a tube to determine the relative coincidence of each marker 14 on die 12 with the projected image of marker 28 on reticle 20. The computer uses these signals to operate the motors 80 and 81 for respectively driving the platform 79 in the X and Y directions to position the image of markers 28 directly in registration with marker 14. Once the wafer 10 is aligned, its position can be subsequently accurately monitored by any suitable means, such as a laser interferometer system (not shown). Such a system will continuously update the computer with signals representative of the change in position of the platform 79.

When accurate registration has been obtained between markers 14 and the image of marker 28, the computer energizes a motor for rotating a shutter which moves to a position where an aperture is provided for viewing marker 16 on die 12 to determine its registration with the projected image of reticle 20. The computer then causes the motor 82 to drive the platform 79 about the center of the chuck 32 until marker 16 registers with the projected image of marker 30.

The adjustments in the X and Y directions by the motors 80 and 81 and in the polar direction by the motor 82 may be continued until alignment is simultaneously provided between markers 14, 16 and the projected images of markers 28, 30.

Upon the occurrence of such simultaneous alignments, a shutter is opened and source 35 is fully energized to expose die 12 to the projected image of the patterns on reticle 20. The die 12 is thereafter treated (by apparatus not constituting this invention) to produce electrical circuitry in accordance with such image.

The pattern on reticle 20 may be reproduced on a plurality of different dies 12 on the wafer 10. Such reproduction is under the control of the computer. However, before such reproduction takes place, the chuck 32 is repositioned so that the markers 14 and 16 on the next die register with the projected images of the markers 28 and 30 on reticle 20. Such realignment is provided in the manner described above.

A focusing system 100 shown in Figs. 4—6, 7 and 8 maintains the projected image of patterns on reticle 20 in focus on die 12. System 100 includes a housing 101 for projection system 50 and a block 102 extending downwardly from the housing 101. The bottom surfaces 103 a, b, c of block 102 extends above the top surface of the chuck 32. Three pneumatic probe lines 104 a, b, c, extend downward through the block 102 to bottom surfaces 103 a, b, c as seen in Figs. 4, 5, 6 et 8. Probe lines 104 a, b, c, communicate with a pressure line 106 extending from a source 108 of pressurized fluid, such as dry nitrogen or clean, dry, compressed air.

The focusing system 100 includes an upper spider assembly 201 and a lower spider assembly 202. The lower assembly has three radial arms 202 a, b, c, each for supporting a servo cylinder and piston assembly 110 a, b, c. The piston 111 of each assembly 110 is connected to the pedestal 33 of chuck 32 by an arm 124 a, b, c, of upper spider 201. Each upper spider arm 124 is connected to the corresponding lower spider arm 202 a, b, c by one of three flexures 112 a, b, c, to permit axial and prevent lateral movement. The three pistons 111 establish three points needed to define a plane parallel to the plane of wafer 10.

As shown in Fig. 5, pedestal 33 comprises a housing 304 within which a plunger 305 is forced up against detent balls 306 by a plurality of springs 307 acting on a spring plate 308. A shaft 309 supports chuck 33 on plunger 305. Microswitches (not shown) are actuated by the plate 308 to shut down the stepper X/Y stage if plunger 305 in knocked off detent balls 306 by accident. The lower spider 202 is supported for rotation in short arcs by pre-loaded vee bearings 113 fixed to the top of platform 79. The 200 step motor 82 drives the 80 pitch screw 83 having a travelling nut 116 attached to spider 202 at a radius of 15.88 cm. This linkage provides a theoretical resolution of 0.1 micron at each end of maximum 21 mm image.

Chuck 32 has a total vertical movement range of 0.227 cm and platform 79 has a 15.88 cm by 30.48 cm travel, which allow the chuck to load and unload itself and to rise above wafer image plane W to contact pre-align microswitches (not shown). A two-stage vacuum source 310 permits skidding the wafer 10 onto chuck 32 at the loading station under light vacuum to "wring it in" flatter on the chuck, after which the pre-align microswitches can be bumped with the wafer at full vacuum without skidding. Concentric grooves 303 between narrow lapped lands 302 on the surface of chuck 32 provide a place for minute particles to settle when the wafer is wrung on at the loading station. The particles are scraped of the underside of the wafer 10 and fall into the grooves 303. Preferably, grooves 303 are substantially wider than lands 302.

Fluid under pressure introduced into the lines 104 a, b, c, through the line 106 from the source 108. The air flows through the lines 104 a, b, c to the bottom of the block 102 and is discharged through orifices 103 a, b, and c. Air flows through the space between bottom surface 103 and the top of the chuck 32. This flow of air provides an air bearing between the block 102 and the chuck 32 to maintain the block and the chuck in spaced relationship. This spacing is in the order of a few thousandths of a millimeter such as 0.076 mm.

Cylinder and piston assemblies 110 a, b and c are disposed at equally spaced positions around the periphery of the chuck. Since the various components associated with each assembly are identical, in the following discussion reference numerals will be used without alphabetic designations, except where required to distinguish one assembly from another. Each of pistons 111 is coupled to the chuck 32 by a rigid arm 124. The vertical disposition of the chuck 32 at a position adjacent to a piston 111 accordingly depends upon the vertical position of the associated arm 124.

The upper end of each assembly 110 is connected to a pressure line 105 which is in fluid communication with a probe line 104. The line 105 communicates with an upper chamber 117 defined at its upper end by a cover plate 118 and at its lower end by a resilient member or diaphragm 119 engaged with piston 111 and made from a suitable material such as rubber. Diaphragm 119 is retained in stretched relationship in chamber 117 by being clamped between the cover plate 118 and the cylinder 120 of assembly 110. Diaphragm 119 engages piston 111 which is vertically moveable in position. Each piston 111 is connected to a radially extending arm 124 which is vertically slidable in a slot 126 through the side of cylinder 120. The flexure 112 is in turn attached at one end to the arm 124 and at the other end to a lower spider arm 202.

A resilient member or diaphragm 130 made from a suitable material such as rubber engages the underside of piston 111 and is retained in a stretched relationship in the lower chamber 131 by being clamped between cylinder 120 and the upper surface of spider assembly 202. Chamber 131 is preferably provided with a fixed pressure such as approximately 7.039 kg/m², or one half the pressure of the source 108, via a pressure line 132.

Figure 6 schematically illustrates how fluid from source 108 is controlled by a pressure regulator 133 to provide a precise output pressure, typically 14.078 kg/m². The regulator can be adjusted to other pressures by precision stepping motor 134. A three-way solenoid valve 135 is operable to turn off air to lines 104 to prevent blowing particles (dust) out of the chuck 32 when no wafer is present. Needle valves 136 control the flow of fluid to orifices (probes) 103. Needle valves 136 are adjusted to provide the same fluid pressure in the air gap as in the lower chamber 131. The lower chambers 131 are held to a predetermined fixed pressure, typically 7.039 kg/m² via line 137, a pressure regulator 138, and feed lines 132. Pressure lines 105 provide fluid communication between the upper chambers 117 and the pressure in air gap Z adjacent the associated orifice 103. A solenoid valve 139 in each pressure line 105 allows the computer to hold the upper chamber 117 at a given pressure before the wafer edge steps from underneath the probe. The air gap Z will develop a given back pressure as a function of the rate of flow. Thus, a change in the setting of the upper regulator 133 will simultaneously change the gap Z of all three orifices 103. the step motor 134 controls regulator 133 and is itself driven by the computer to permit initial focus adjustments.

Each pressure line 105 receives air at the same pressure as that in the line 104. When the pressure of the air in the lines 104 and 105 increases due, for example, to a decrease in air gap Z upon placement of a wafer 10 on chuck 32, an increased pressure is produced in the chamber 117. This pressure is exerted downwardly against diaphragm 119, so that piston 111 and arm 124 are accordingly moved downwardly against the force exerted by the pressure in lower chamber 131 acting on lower diaphragm 130, which acts as a return spring. The resultant movement downwardly of the arm 124 produces a corresponding movement downwardly of the chuck 32.

As the chuck 32 is moved downwardly, air gap Z is increased. This relieves the pressure of the air in the line 104 so that the pressure of the air in the line is regulated at a substantially constant value. As will be seen from the above discussion, the chuck 32 is wobbled individually by each of the piston and cylinder assembles 110 in a direction transverse to the X—Y plane of movement of the chuck. In this way, the gap between the block 102 and a wafer on chuck 32 is regulated to maintain the die 12 on the wafer in focus with the projected image of pattern of reticle 20.

The invention is particularly useful in microlithography systems. Of course, many other applications requiring one-to-one magnification will occur to those skilled in the optical arts.

**Claims**

1. A system for focusing a wafer (10) by positioning said wafer (10) in the focal plane of an optical system in an apparatus such as a projection stepping machine for microlithographically forming patterns on semiconductor wafers having
— a pneumatic motor (110) for moving said wafer (10) through a plurality of parallel planes including a focalplane;
— a pneumatic power source (108) for powering said motor;
— means (102) for generating a fluid pressure signal representative of the distance of said wafer from said focal plane;
characterized in that it comprises pneumatic conduit means (104, 105, 106) connected to said generating means (102) said power source (108) and said motor (110) for conveying said fluid pressure signal and said fluid driving power to said motor (110) for actuating said motor in response to changes in said signal to adjust the distance between said wafer (10) and said focal plane and thereby positioning said wafer (10) in said focal plane directly through fluidic means.

2. A projection stepping machine having a focusing system, said machine being of the type including an illumination system for substantially uniformly illuminating a reticle having a pattern with an area substantially smaller than that of a wafer on which an image of said pattern is to be projected; a stationary projection optical system for projecting an image identical in size and form to said pattern onto a predetermined focal plane; an alignment system for detecting the presence of a marker on a wafer; and a platform (79) responsive to said alignment for supporting a wafer and for moving said wafer to align at least a portion of said wafer corresponding in area to the area of said pattern with the projected image of said pattern, characterized by the focusing system as claimed in claim 1, said fluid servo focusing system (100) being connected to said platform (79).

3. A projection stepping machine as claimed in claim 2 characterized in that it comprises means (80, 81) coupled to said platform (79) for moving said wafer (10) an incremental step to position a further portion of said wafer for exposure to said projected image.

4. A projection stepping machine as claimed in claim 2, characterized in that said focusing means comprise:
— three fluid probe means (103a, B, C) spaced from said focal plane for directing a stream of fluid against said wafer (10);
— three fluid operated pistons (111a, b, c) coupled to said platform (79) and biased on one side to move said wafer (10) in a direction opposite to said stream;
— three fluid signal lines (104a, b, c; 105a, b, c) connecting respective probe means (403a, b, c) and to said pistons (111a, b, c) for directly transmitting to the other side of said piston a fluid pressure signal that is inversely proportional in magnitude to the distance between said wafer (10) and said probe (103), and thereby apply a fluid force to said other side that is inversely proportional to the distance between said probe means (103) and said wafer (10), so that said piston (111) is moved under the influence of said bias and said fluid pressure signal until the two cancel one another and the wafer (10) comes to rest at said focal plane.

5. A projection stepping machine as claimed in claim 4, characterized in that it further comprises a lower spider (202) mounted on said platform (79) and provided with a central opening and three radial arms (202å, b, c) each of which supports a cylinder (120) for one of said pistons (111a, b, c); a wafer chuck (32) disposed in said central opening; and an upper spider (201) having three radial arms (124a, b, c) each of which extends from one of said pistons (111a, b, c) to said chuck (32) for transmitting movement of said pistons to said chuck.

6. A projection stepping machine as claimed in claim 5, characterized in that it further comprises three flexures (112a, b, c), each flexure connected between an upper spider arm (201) and an adjacent lower spider arm (202a, b, c) to provide lateral stability for the upper spider arms (124).

7. A projection stepping machine as claimed in claim 6, characterized in that said piston (111a, b, c) is enclosed in a chamber having a peripheral wall, further in that it comprises two diaphragms (119a, 130) positioned on opposite sides of said pistons to define an upper chamber (117a) and a lower chamber (131), and in that the pressure in one chamber is maintained at a predetermined level and the pressure in the other chamber is a function of said fluid signal.

8. A projection stepping machine as claimed in claim 2, characterized in that it further comprises:
— means for holding a reticle (20) having a plurality of patterns thereon;
— means (27) coupled to said platform (79) for advancing a reticle (20) in said holding means to individually project an image of one of said patterns onto said wafer;
— means (25, 27) responsive to the projection of an image of one of said patterns onto said wafer (10) for selectively operating said advancing means in order to project an image of another of said patterns onto said wafer (10).

9. A projection stepping machine as claimed in claim 2, characterized in that it comprises means for increasing the output of an illumination system (35) of said projection optical system to a level sufficient to expose a photosensitive layer on a wafer (10).

**Revendications**

1. Système de mise au point d'une plaquette (10) propre à maintenir ladite plaquette (10) dans le plan focal d'une image d'un système optique dans un appareil tel qu'un projecteur à avances successives, destiné à former des dessins par microlithographie sur des semi-conducteurs sous forme de plaquette du genre comprenant:
— un moteur pneumatique (110) destiné à déplacer la plaquette (10) suivant plusieurs plans parallèles, dont l'un est un plan focal;
— une source d'énergie pneumatique (108) pour alimenter le moteur;
— des moyens (102) pour engendrer un signal de pression de fluide représentatif de la distance qui sépare la plaquette et le plan focal;
caractérisé en ce qu'il comprend des conduits pneumatiques (104, 105, 106) reliés audit moyen générateur (102), à ladite source d'énergie (108) et audit moteur (110), en vue d'acheminer ledit signal de pression de fluide et ladite énergie de commande fluidique audit moteur (110) afin de l'actionner en réponse aux variations dudit signal en vue de régler la distance entre ladite plaquette (10) et ledit plan focal pour disposer ainsi ladite plaquette (10) dans ledit plan focal directement par l'intermédiaire des moyens fluidiques.

2. Appareil de projection à avances successives comportant un système de mise au point, du genre comprenant un système d'éclairage pour illuminer de manière substantiellement uniforme un réticule comportant un dessin d'une surface plus petite que celle d'une plaquette, sur laquelle un image dudit dessin doit être projetée, un système optique fixe propre à projeter dans un plan focal pré-determiné, une image identique en dimension et en forme audit dessin; un système

d'alignement pour détecter la présence d'un repère sur une plaquette; et une plateforme (79) qui répond audit système d'alignement pour supporter une plaquette et pour la déplacer en vue d'aligner avec l'image projetée dudit dessin une partie au moins de ladite plaquette, dont la surface correspond à celle dudit dessin, caractérisé en ce que dans le système de mise au point suivant la revendication 1, ledit système de mise au point par servo fluide (100) est relié à ladite plateforme (79).

3. Appareil de projection à avances successives suivant la revendication 2, caractérisé en ce qu'il comporte des moyens (80, 81) accouplés à ladite plateforme (79) pour déplacer ladite plaquette (10) d'un incrément, afin de mettre en position une partie ultérieure de cette plaquette en vue de son exposition à ladite image projetée.

4. Appareil de projection à avances successives suivant la revendication 2, caractérisé en ce que les moyens de mise au point comprennent:
— trois dispositifs de sonde à fluide (103a, b, c) placés à une certaine distance du plan focal précité pour envoyer un courant de fluide contre ladite plaquette (10);
— trois pistons (111a, b, c) actionnés par fluide, accouplés à ladite plateforme (79) et rappelés sur une de leurs faces, de façon à déplacer la plaquette (10) dans une direction opposée audit courant, et
— trois lignes de signal fluidique (104a, b, c) reliées aux dispositifs de sondes respectifs (403a, b, c) et auxdits pistons (111a, b, c) pour transmettre directement à l'autre face de ce dernier, un signal de pression fluidique de valeur inversement proportionnelle à la distance qui sépare la plaquette (10) et le dispositif de sonde (103), de sorte que le piston (111) se trouve déplacé sous l'action du système de rappel et du signal de pression fluidique précité jusqu'à ce que les deux s'équilibrent et que la plaquette (10) vienne s'arrêter dans ledit plan focal.

5. Appareil de projection à avances successives suivant la revendication 4, comprenant en outre un croisillon inférieur (202) monté sur ladite plateforme (79), ce croisillon comportant une ouverture centrale et trois bras radiaux (202a, b, c), dont chacun supporte un cylindre (120) destiné à recevoir l'un desdits pistons (111a, b, c); un mandrin (32) situé dans ladite ouverture centrale et un croisillon supérieur (201) pourvu de trois bras (124a, b, c), dont chacun s'étend de l'un desdits pistons (111a, b, c) audit mandrin pour transmettre à ce dernier les mouvements de ceux-ci.

6. Appareil de projection à avances successives suivant la revendication 5, caractérisé en ce qu'il comprend en outre trois parties fléchissantes (112a, b, c) dont chacune forme liaison entre un bras supérieur (201) du croisillon et le bras adjacent (202a, b, c) du croisillon inférieur de façon à assurer la stabilité latérale des bras (124) du croisillon supérieur.

7. Appareil de projection à avances successives suivant la revendication 6, caractérisé en ce que le piston (111a, b, c) qu'il comprend, est enfermé dans une chambre comportant une paroi périphérique et comprenant en outre, deux membranes (119a, 130) disposées sur les faces opposées des pistons de façon à définir une chambre supérieure (117a) et une chambre inférieure (131) et en ce que la pression est maintenue à un niveau prédéterminé dans une chambre et est fonction du signal fluide dans l'autre chambre.

8. Appareil de projection à avances successives suivant la revendication 2, caractérisé en ce qu'il comprend en outre:
— des moyens pour retenir un réticule (20) comportant sur lui plusieurs dessins;
— des moyens (25, 27) accouplés à ladite plateforme (79) pour faire avancer un réticule (20) dans les moyens de retenue, afin de projeter individuellement sur la plaquette, une image de l'un de ces dessins;
— des moyens (25, 27) qui répondent à la projection d'une image de l'un desdits dessins sur la plaquette (10) pour actionner sélectivement les moyens d'avance en vue de projeter sur cette plaquette (10) l'image d'un autre desdits dessins.

9. Appareil de projection à avances successives suivant la revendication 2, caractérisé en ce qu'il comprend:
— des moyens pour élever la puissance dudit système d'éclairage (35) dudit système optique de projection à un niveau suffisant pour exposer une couche photo-sensible sur une plaquette (10).

**Patentansprüche**

1. System zum Fokussieren eines Plättchens (10) durch Positionieren des Plättchens (10) in der Brennebene eines optischen Systems in einer Vorrichtung, wie z. B. einer Projektionsschittschaltmaschine zum mikrolithographischen Formen von Mustern auf Halbleiterplättchen, mit
— einem pneumatischen Motor (110) zum Bewegen des Plättchens (10) durch eine Mehrzahl paralleler Ebenen einschließlich einer Brennebene;
— einer pneumatischen Energiequelle (108) zum Speisen des Motors;
— Mitteln (102) zum Erzeugen eines den Abstand des Plättchens von der Brennebene anzeigenden Fluiddrucksignals;
dadurch gekennzeichnet,
daß es pneumatische Leitungselemente (104, 105, 106) in Verbindung mit den Erzeugungsmitteln (102), der Energiequelle (108) und dem Motor (110) zum Leiten des Fluiddruckssignals und der Fluidantriebskraft zum Motor (110) zwecks Betätigung des Motors im Ansprechen auf Änderungen des Signals zum Justieren des Abstands zwischen dem Plättchen (10) und der Brennebene und dadurch zum Positionieren des Plättchens (10) in der Brennebene direkt durch Fluidmittel aufweist.

2. Projektionsschrittschaltmaschine mit einem Fokussierungssystem, welche Maschine vom Typ einschließlich eines Beleuchtungssystems zum im wesentlichen gleichmäßigen Beleuchten eines Fadenkreuzes, das ein Muster mit einer wesentlich kleineren Fläche als der eines Plättchens ist, auf das ein Bild des Musters zu projizieren ist; eines stationären optischen Projektionssystems zur Projektion eines in Abmessung und Form dem Muster identischen Bildes auf eine vorbestimmte Brennebene; eines Ausrichtungssystems zum Erfassen des Vorliegens einer Markierung auf einem Pkättchen; und einer Plattform (79) ist, die auf diese Ausrichtung zum Halten eines Plättchens und zum Bewegen des Plättchens zwecks Ausrichtung wenigstens eines flächenmäßig der Fläche des Musters entsprechenden Teils des Plättchens mit dem projizierten Bild des Musters anspricht, gekennzeichnet durch das im Anspruch 1 beanspruchte Fokussiersystem, wobei das Fluidservofokussiersystem (100) mit der Plattform (79) verbunden ist.

3. Projektionsschrittschaltmaschine nach Anspruch 2, dadurch gekennzeichnet,

daß sie mit der Plattform (79) verbundene Mittel (80, 81) zum Bewegen des Plättchens (10) um einen Teilschritt zum Positionieren eines weiteren Teils des Plättchens zur Aufnahme des projizierten Bildes aufweist.

4. Projektionsschrittschaltmaschine nach Anspruch 2, dadurch gekennzeichnet,

daß die Fokussiermittel aufweisen:

— drei Fluidsondenorgane (103a, B, C) unter Abstand von der Brennebene zum Richten eines Fluidstroms gegen das Plättchen (10);

— drei fluidbetätigte Kolben (111a, b, c), die mit der Plattform (79) verbunden und an einer Seite vorgespannt sind, um das Plättchen (10) in einer dem Strom entgegengesetzten Richtung zu bewegen;

— drei Fluidsignalleitungen (104a, b, c; 105a, b, c) zur Verbindung einzelner Fluidsondenorgane (403a, b, c) und mit den Kolben (111a, b, c) zum direkten Leiten eines Fluiddrucksignals zur anderen Seite des Kolbens, das in seiner Größe dem Abstand zwischen dem Plättchen (10) und der Sonde (103) umgekehrt proportional ist, und dadurch zum einwirken einer Fluidkraft an der anderen Seite, die dem Abstand zwischen dem Sondenorgan (103) und dem Plättchen (10) umgekehrt proportional ist, so daß der Kolben (111) unter dem Einfluß der Vorspannung und des Fluiddrucksignals bewegt wird, bis sich die beiden gegenseitig aufheben und das Plättchen (10) in der Brennebene zur Ruhe kommt.

5. Projektionsschrittschaltmaschine nach Anspruch 4, dadurch gekennzeichnet,

daß sie weiter aufweist:

einen unteren Speichenstern (202), der an der Plattform (79) montiert und mit einer Mittenöffnung und drei radialen Armen (202a, b, c) versehen ist, deren jeder einen Zylinder (120) für einen der Kolben (111a, b, c) trägt; ein in der Mittenöffnung angeordnetes Plättchenspannfutter (32); und

einen oberen Speichenstern (201) mit drei radialen Armen (124a, b, c), deren jeder sich von einem der Kolben (111a, b, c) zum Spannfutter (32) zwecks Übertragung der Bewegung der Kolben auf das Spannfutter erstreckt.

6. Projektionsschrittschaltmaschine nach Anspruch 5, dadurch gekennzeichnet,

daß sie weiter drei Streben (112a, b, c) aufweist, deren jede zwischen einem oberen Speichensternarm (201) und einem benachbarten unteren Speichensternarm (202a, b, c) angeschlossen ist, um seitliche Stabilität für die oberen Speichensternarme (124) zu ergeben.

7. Projektionsschrittschaltmaschine nach Anspruch 6, dadurch gekennzeichnet,

daß der Kolben (111a, b, c) in einer Kammer mit einer Umfangswand eingeschlossen ist und daß sie weiter zwei Membranen (119a, 130) aufweist, die an entgegengesetzten Seiten der Kolben zur Begrenzung einer oberen Kammer (117a) und einer unteren Kammer (131) angeordnet sind, und daß der Druck in einer Kammer auf einem vorbestimmten Niveau gehalten wird und der Druck in der anderen Kammer eine Funktion des Fluidsignals ist.

8. Projektionsschrittschaltmaschine nach Anspruch 2, dadurch gekennzeichnet,

daß sie weiter aufweist:

— Mittel zum Halten eines Fadenkreuzes (20) mit einer Mehrzahl von Mustern darauf;

— ein mit der Plattform (79) verbundenes Mittel (27) zum Vorrücken eines Fadenkreuzes (20) im Haltemittel zum einzelnen Projizieren eines Bildes eines der Muster auf das Plättchen;

— Mittel (25, 27), die auf die Projektion eines Bildes eines der Muster auf das Plättchen (10) zur selektiven Betätigung des Vorrückmittels, um ein Bild eines anderen der Muster auf das Plättchen (10) zu projizieren.

9. Projektionsschrittschaltmaschine nach Anspruch 2, dadurch gekennzeichnet,

daß sie Mittel zum Steigern des Ausgangs eines Beleuchtungssystems (35) des optischen Projektionssystems auf ein ausreichendes Niveau zur Belichtung einer lichtempfindlichen Schicht auf einem Plättchen (10) aufweist.

Fig.1.

Fig.2.

Fig.8.

Fig.3.

Fig.4.

Fig.5.

Fig.6.

Fig. 7.

0 078 323